# EUROPEAN PATENT APPLICATION

(11) **EP 1 729 350 A2**
(43) Date of publication of application: **06.12.2006**
(21) Application number: 06252802.1
(22) Date of filing: 31.05.2006
(51) Int. Cl.: H01L 33/00, H01L 25/075

(54) **Light emitting diode package**

(30) Priority: 31.05.2005 KR 20050046473
(71) Applicant: Samsung Electro-Mechanics Co., Ltd., Suwon, Kyungki-do (KR)
(72) Inventor: Lim, Chang Hyun, Daeku (KR); Choi, Seog Moon, Kwanaka-ku Seoul (KR); Jeung, Won Kyu, Seocho-ku Seoul (KR)
(74) Representative: Powell, Timothy John

(57) **Abstract**

The invention relates to an LED package capable of effectively mixing different colors of lights emitted from a plurality of LEDs to be focused into a desired region. The LED package includes a plurality of LEDs disposed on a substrate, and a side wall formed around an area with the LEDs disposed therein. The LED package also includes a diffusion plate disposed above in a predetermined interval from the LEDs and fixed to the side wall, and a micro lens array disposed above in a predetermined interval from the diffusion plate and fixed to the side wall.

## Description

### CLAIM OF PRIORITY

This application claims the benefit of Korean Patent Application No. 2005-46473 filed on May 31, 2005, in the Korean Intellectual Property Office, the disclosure of which is incorporated herein by reference.

### BACKGROUND OF THE INVENTION

### Field of the Invention

The present invention relates to a light emitting diode (LED) package, and more particularly, an LED package for illumination purpose which diffuses different colors of lights emitted from a plurality of LEDs using a diffusion plate, reducing the distance needed for the lights to be mixed, and focuses the lights diffused by the diffusion plate into a desired illumination region using a micro lens array.

### Description of the Related Art

Recently, a light emitting diode (LED) has been gaining popularity as the next-generation light source for illumination with its merits like low power consumption, long lifetime, and high reliability.

In general, a white light source for illumination purpose is manufactured using a blue LED emitting blue light and yellow phosphor, using a UV LED emitting ultraviolet light and red, green and blue phosphors, or using red, green, and blue LEDs emitting red, green, and blue lights to be mixed. Particularly, mixing different colors of light does not require phosphors, thus free from the problems resulting from transformations of the phosphors, and allows adjusting the luminance of each color with a high degree of freedom in colors.

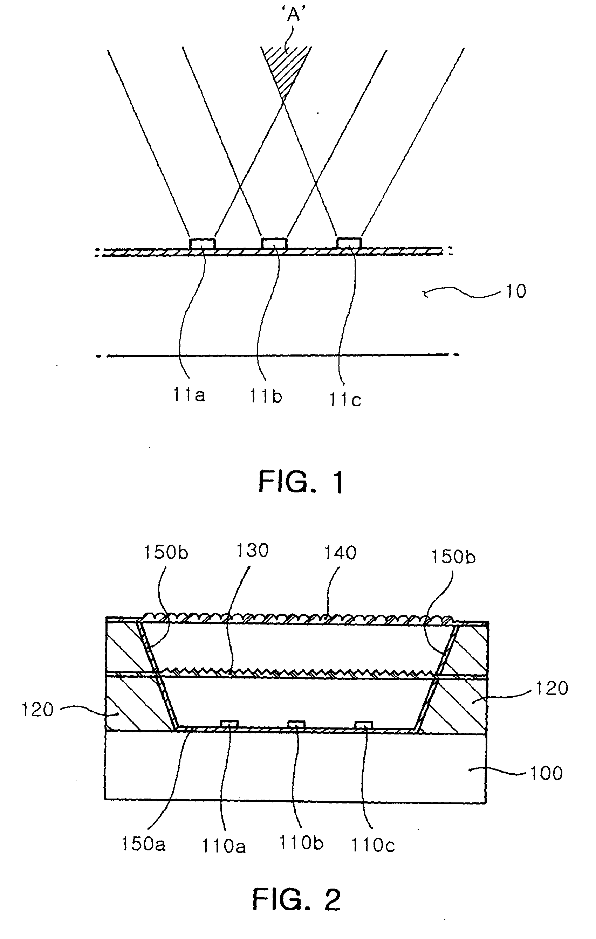

FIG. 1 is a schematic view illustrating the mixing different colors of lights in a conventional LED package. In the conventional LED package, a red LED 11a, a green LED 11b, and a blue LED 11c are disposed adjacent to each other on a substrate 10 to emit red light, green light and blue light which are mixed together while traveling.

In this conventional method, however, since the light is emitted from the LED within a predetermined angle in general, region A in which all three colors of lights are mixed is very small. Thus, light mixing does not take place within a predetermined distance, resulting in problems such as color spots observed in the light emitted from the LED package.

In addition, trying to ensure a sufficient distance from the LED to increase the region of light mixing of the three colors inevitably entails increase in the LED package size.

Therefore, there has been a demand for an LED package which enables miniaturization as well as uniform mixing of the colors.

### SUMMARY OF THE INVENTION

The present invention has been made to solve the foregoing problems of the prior art and it is therefore an object of the present invention to provide a light emitting diode (LED) package capable of uniformly mixing different colors of lights emitted from a plurality of LEDs to generate white light, with a miniaturized package size.

According to an aspect of the invention for realizing the object, there is provided a light emitting diode (LED) package including: a substrate; a plurality of LEDs disposed on the substrate; a side wall formed around an area with the plurality of LEDs disposed therein; a diffusion plate disposed above and apart in a predetermined interval from the plurality of LEDs and fixed to the side wall; and a micro lens array disposed above and apart in a predetermined interval from the diffusion plate, and fixed to the side wall.

According to one embodiment of the present invention, the plurality of LEDs include at least two LEDs for emitting complementary colors of light. In another embodiment of the invention, the plurality of LEDs comprise at least one LED emitting a red light, at least one LED emitting green light, and at least one LED emitting blue light.

Preferably, the diffusion plate has a plurality of prism structures formed thereon, and the prism structure may have a shape of a triangular pyramid or a square pyramid.

Preferably, the substrate has a reflective film formed thereon. In addition, the side wall has a sloped surface formed around the area with the plurality of LEDs disposed therein, and the sloped surface preferably has a reflective film coated thereon.

Preferably, each micro lens of the micro lens array comprises a lower part having a hexagonal cross-section.

Preferably, the diffusion plate and the micro lens array are made of polymer having optical properties.

### BRIEF DESCRIPTION OF THE DRAWINGS

The above and other objects, features and other advantages of the present invention will be more clearly understood from the following detailed description taken in conjunction with the accompanying drawings, in which:

FIG. 1 is a schematic view illustrating light mixing in a conventional LED package;

FIG. 2 is a side sectional view of an LED package according to one embodiment of the present invention;

FIGS. 3 (a) and 3 (b) are perspective views illustrating prism structures formed on a diffusion plate according to one embodiment of the present invention;

FIGS. 4a to 4e illustrate various structures of a micro lens adopted in the present invention;

FIG. 5(a) is a schematic view illustrating light diffusion effect adopted in the present invention, and FIG. 5 (b) is a schematic view illustrating light focusing effect of the micro lens array adopted in the present invention;

FIG. 6 is a schematic view illustrating expansion of a light mixing region due to the light diffusion effect of the diffusion plate adopted in the present invention; and

FIG. 7 is a schematic view illustrating light emission process of the LED package according to the present invention.

### DETAILED DESCRIPTION OF THE PREFERRED EMBODIMENT

The present invention now will be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the shapes and dimensions are exaggerated for clarity, and the same reference numerals are used throughout to designate the same or similar components.

FIG. 2 is a side sectional view of a light emitting diode (LED) package according to one embodiment of the present invention. As shown in FIG. 2, the LED package according to one embodiment of the present invention includes a substrate 100; a plurality of LEDs 110a to 110c disposed on the substrate 100; a side wall 120 formed around an area with the plurality of LEDs 110a to 110c disposed therein; a diffusion plate 130 disposed above in a predetermined interval from the plurality of LEDs and fixed to the side wall 120; and a micro lens array 140 disposed above in a predetermined interval from the diffusion plate 130 and fixed to the side wall 120.

The substrate 100 is for disposing the plurality of LEDs 110a to 110c and the side wall 120 thereon, and can adopt a generally known printed circuit board, ceramic substrate, and Si substrate. In case of using a Si substrate, however, a dielectric film can be formed thereon since Si is conductive. The substrate 100 has an upper surface area for disposing the plurality of LEDs thereon and another upper surface area for forming the side wall 120 thereon. In addition, a lead pattern (not shown) may be electrically connected to electrodes of the plurality of LEDs 110a to 110c on an upper surface of the substrate 100 for supplying power to the plurality of LEDS 110a to 110c. In addition, the substrate 100 may have an external terminal (not shown) or a conductive via (not shown) on an undersurface, side surface or inside thereof for supplying power to the lead pattern. The substrate may have a reflective film 150a formed thereon. The reflective film 150a reflects the light, directed to the upper surface of the substrate, upward to increase the amount of light emitted from the LED package.

The plurality of LEDs 110a to 110c are disposed on the substrate 100, and the electrode of each LED is electrically connected to the lead pattern (not shown) formed on the substrate 100. The plurality of LEDs 110a to 110c emit different colors of lights which are mixed inside the LED package to be emitted out of the package. For example, in case of an LED package for emitting white light appropriate for general illumination, the plurality of LEDs 110a to 110c may include at least two LEDs emitting complementary colors of light, or may include at least one LED emitting red light, at least one LED emitting green light and at least one LED emitting blue light. FIG. 2 illustrates an embodiment in which the LED package for generating white light includes at least one LED 110a for emitting red light, at least one LED 110b for emitting green light, and at least one LED 110c for emitting blue light, which however does not limit the present invention.

The side wall 120 is formed around an area where the plurality of LEDS 110a to 110c are disposed on the substrate 100. The inner side surface of the side wall 120, that is, the side surface surrounding the area with the LEDs 110a to 110c disposed therein, is a sloped surface. It is preferable that the sloped surface has a reflective film 150b formed thereon in the same manner as the upper surface of the substrate 100 to reflect light upward from the LED package. The side wall 120 is fixing means for fixing the diffusion plate 130 disposed above in a predetermined interval from the plurality of LEDs 110a to 110c and a micro lens array 140 disposed above in a predetermined interval from the diffusion plate 130.

The diffusion plate 130 is disposed above in a predetermined interval from the plurality of LEDs 110a to 110c and fixed to the side wall. The diffusion plate 130 diffuses the lights emitted from the plurality of LEDs 110a to 110c. That is, the lights emitted from the plurality of LEDs 110a to 110c are diffused broadly in a horizontal direction as they pass through the diffusion plate 130. Therefore, the light mixing region is further increased. The diffusion plate 130 may be manufactured in various forms. For example, the diffusion plate may be a transparent plate capable of transmitting light, coated on one surface thereof with diffusion material together with binding resin, etc. In another example, the diffusion plate may be manufactured as a transparent plate having a plurality of prism structures. The diffusion plate with the diffusion material coated thereon entails a difficult coating process for closely adhering the diffusion material to the diffusion plate. Therefore, it is preferable for the present invention to use the diffusion plate with a plurality of prism structures thereon.

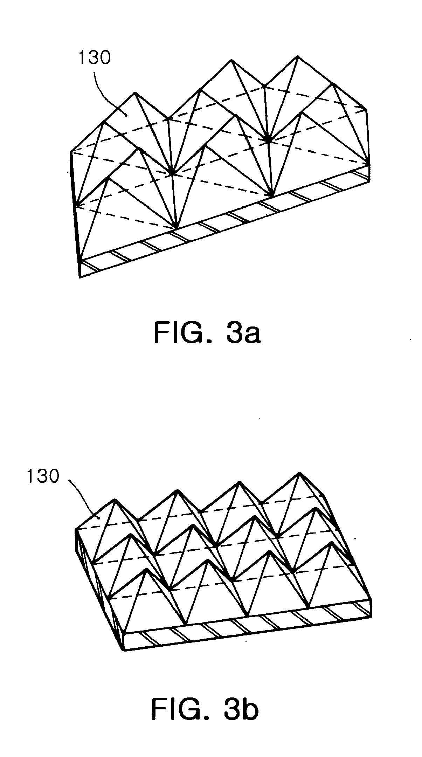

FIG. 3(a) and (b) illustrate examples of prism structures formed on the diffusion plate 130 (FIG. 2). FIG. 3(a) illustrates an example in which prism structures each having a shape of a triangular pyramid are disposed next to each other without any gaps, and FIG. 3(b) illustrates an example in which prism structures each having a shape of a square pyramid are disposed next to each other without any gaps. As shown in FIGS. 3(a) and (b), forming the plurality of prism structures each in a shape of a triangular pyramid or a square pyramid prevents gaps, where no prism structure is disposed, between the prism structures, thereby further enhancing the light diffusion effect of the diffusion plate. Such prism structures each having a shape of a triangular pyramid or a square pyramid can be mass-manufactured relatively easily using transparent polymer by a duplication technique.

Back to FIG. 2, the micro lens array 140 is disposed above in a predetermined interval from the diffusion plate 130 and fixed to the side wall 120. The micro lens array 140 functions to focus the lights diffused and mixed through the diffusion plate 130 into a desired region. The lights emitted from the plurality of LEDs 110a to 110c are diffused as they pass through the diffusion plate 130 and mixed well at a short distance, forming a desired color of light. However, as the lights are diffused broadly, the amount of light to be irradiated to the desired region is decreased. Therefore, the micro lens array 140 refracts the light diffused by the diffusion plate 130 and focuses the lights into a desired region.

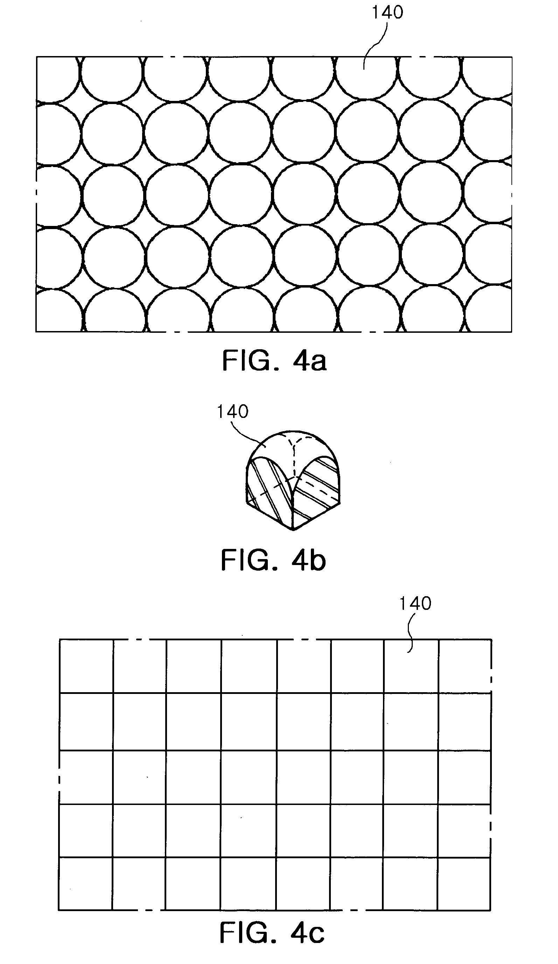

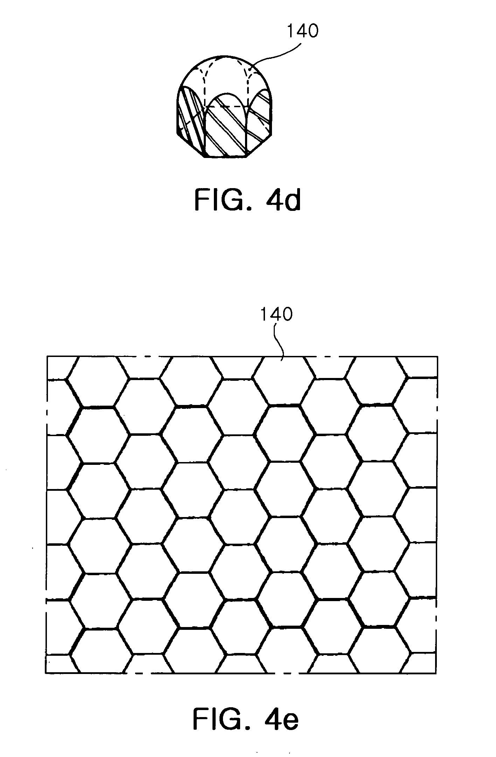

The micro lens array 140 is composed of hemispherical lenses in a micro size, and can be manufactured with polymer having optical properties using a duplication technique, in the same manner as the prism structures of the diffusion plate 130. FIGS. 4a to 4e are diagrams illustrating various structures of the micro lens array. FIG. 4a is a plan view of a part of the micro lens array. As shown in FIG. 4a, with the hemispherical micro lenses disposed closely next to each other, there remains a gap X where no lens is disposed between the micro lenses. The light that is transmitted through the gap X without any lens cannot be refracted by the micro lens array, and thus is not irradiated to the desired region. Therefore, it is preferable not to have any gaps where the lenses are not formed. To solve such a problem, it is preferable to adopt a micro lens having a lower part with a square cross-section as shown in FIG. 4b, or a hexagonal cross-section as shown in FIG. 4d. FIGS. 4c and 4e are plan views of the micro lens arrays with the plurality of micro lenses illustrated in FIGS. 4b and 4d disposed next to each other without any gaps. As shown in FIGS. 4c and 4e, the micro lenses each having a square or a hexagonal cross-section are disposed next to each other without any gaps where no lens is disposed. This allows maximum effect in refracting and focusing the light into the desired region.

It is preferable that the diffusion plate 130 and the micro lens array 140 are made of polymer. Polymer having optical properties refers to polymer material having appropriate refractive index and contraction ratio for its use in an optical device.

The operational effect of the LED package having the above described configuration according to the present invention will now be described hereinafter with reference to the accompanying drawings.

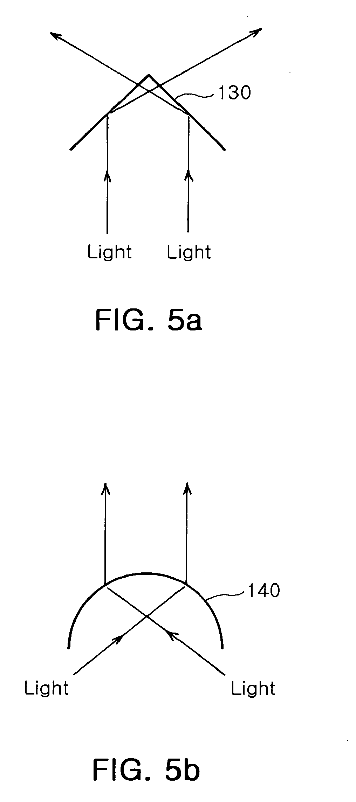

FIGS. 5 (a) and (b) are schematic views illustrating the light diffusion and light focusing operations of the diffusion plate and the micro lens array according to the present invention.

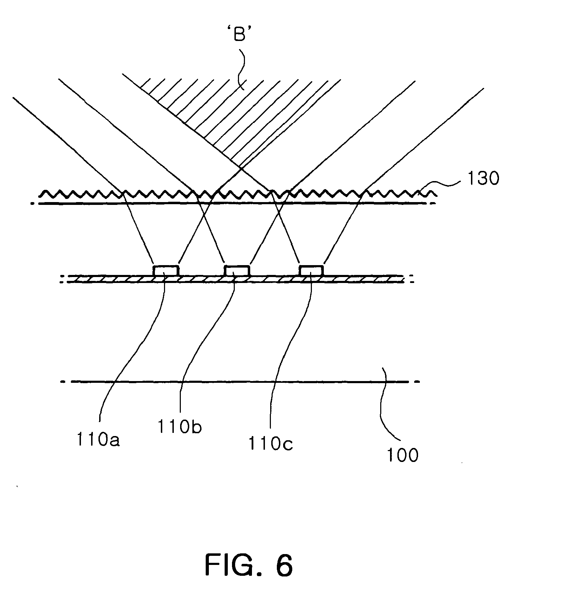

First, as shown in FIG. 5, the lights incident into the diffusion plate 130 are reflected by the surface of the prism structures each having a triangular pyramid or a square pyramid on the diffusion plate 130 to be diffused sideward. FIG. 6 illustrates the expanded light mixing region due to such light diffusion effect. As shown in FIG. 6, diffusion of the lights allows a greater light mixing region B in which all three colors are mixed, thereby allowing the lights to be mixed at a short distance. Next, as shown in FIG. 5(b), lights incident into the micro lens of the micro lens array 140 are refracted at the surface of the micro lens and outputted in parallel to be focused into a desired illumination region.

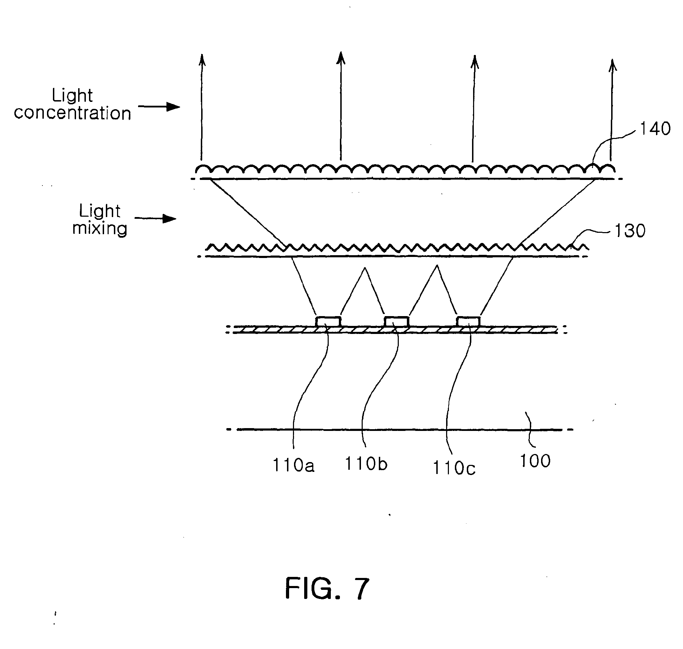

FIG. 7 illustrates overall light emission process in the LED package according to the present invention. As shown in FIG. 7, the lights emitted in a predetermined angle from the plurality of LEDs 110a to 110c disposed on the substrate 100 pass through the diffusion plate 130 and are diffused sideward. The diffused lights are mixed to form a desired color of light and are incident into the micro lens array 140. The micro lens array 140 refracts the diffused and mixed light and outputs the light in parallel, focused into a region requiring illumination. In the present invention, light mixing takes place between the diffusion plate 130 and the micro lens array 140, and therefore, the distance therebetween can be appropriately adjusted to enable more advantageous and uniform light mixing.

As set forth above, according to the present invention, lights emitted from LEDs are diffused sideward using a diffusion plate, and thus different colors of lights are mixed at a short distance, thereby allowing miniaturization of an LED package and generation of uniform white light. In addition, the lights diffused by the diffusion plate are refracted by a micro lens array to be focused into a desired region for illumination.

While the present invention has been shown and described in connection with the preferred embodiments, it will be apparent to those skilled in the art that modifications and variations can be made without departing from the spirit and scope of the invention as defined by the appended claims.

## Claims

1. A light emitting diode (LED) package comprising:
a substrate;
a plurality of LEDs disposed on the substrate;
a side wall formed around an area with the plurality of LEDs disposed therein;
a diffusion plate disposed above and apart in a predetermined interval from the plurality of LEDs and fixed to the side wall; and
a micro lens array disposed above and apart in a predetermined interval from the diffusion plate, and fixed to the side wall.

2. The LED package according to claim 1, wherein the plurality of LEDs comprise at least two LEDs for emitting complementary colors of light.

3. The LED package according to claim 1, wherein the plurality of LEDs comprise at least one LED emitting a red light, at least one LED emitting green light, and at least one LED emitting blue light.

4. The LED package according to claim 1, wherein the diffusion plate has a plurality of prism structures formed thereon.

5. The LED package according to claim 4, wherein the prism structure has a shape of a triangular pyramid or a square pyramid.

6. The LED package according to claim 1, wherein the substrate has a reflective film formed thereon.

7. The LED package according to claim 1, wherein the side wall has a sloped surface formed around the area with the plurality of LEDs disposed therein, the sloped surface having a reflective film coated thereon.

8. The LED package according to claim 1, wherein each micro lens of the micro lens array comprises a lower part having a hexagonal cross-section.

9. The LED package according to claim 1, wherein the diffusion plate and the micro lens array are made of polymer having optical properties.
